Europäisches Patentamt

European Patent Office

Office européen des brevets

(19)

(11) EP 0 511 707 B1

(12) FASCICULE DE BREVET EUROPEEN

(45) Date de publication et mention
de la délivrance du brevet:
03.04.1996 Bulletin 1996/14

(51) Int Cl.6: H03F 1/32, H03F 3/45

(21) Numéro de dépôt: 92201133.3

(22) Date de dépôt: 22.04.1992

(54) **Amplificateur différentiel notamment du type à cascode**

Kaskodendifferenzverstärker

A cascode differential amplifier

(84) Etats contractants désignés:
DE FR GB IT

(30) Priorité: 30.04.1991 FR 9105291

(43) Date de publication de la demande:
04.11.1992 Bulletin 1992/45

(73) Titulaires:
• PHILIPS COMPOSANTS
F-92150 Suresnes (FR)
Etats contractants désignés:
FR
• Philips Electronics N.V.
NL-5621 BA Eindhoven (NL)
Etats contractants désignés:
DE GB IT

(72) Inventeur: Barbu, Stéphane
F-75008 Paris (FR)

(74) Mandataire: Charpail, François et al
Société Civile S.P.I.D.
156, Boulevard Haussmann
F-75008 Paris (FR)

(56) Documents cités:
EP-A- 0 275 079          EP-A- 0 284 092
EP-A- 0 353 742

**Description**

La présente invention concerne un amplificateur comportant un étage différentiel muni de deux paires de transistors d'entrée, disposées entre une borne d'alimentation et une borne de référence, dans lesquelles une paire appelée paire principale de transistors d'entrée est alimentée par ses émetteurs réunis, par une source de courant d'émetteur qui est connectée par ailleurs à la borne de référence, et une autre paire appelée paire annexe de transistors d'entrée, est alimentée de manière similaire par ses émetteurs réunis, les bases des transistors de la paire principale étant réunies aux bases homologues des transistors de la paire annexe, et formant les bornes d'entrée pour des tensions d'entrée - tensions d'entrée dont la différence définit une tension différentielle d'entrée - tandis qu'au moins une partie des courants des collecteurs des transistors de la paire annexe est utilisée en sommation convenable avec les courants des collecteurs des transistors de la paire principale - laquelle sommation formant des courants de sortie de l'étage différentiel - en vue d'augmenter la linéarité de ces courants de sortie par rapport à la tension différentielle d'entrée.

Un tel étage différentiel destiné à être incorporé dans un amplificateur est connu du document JP-A-57 53114. Selon ce document, le courant fourni par les collecteurs des transistors de la paire annexe d'entrée est retourné au moyen de miroirs de courant vers les collecteurs des transistors opposés de la paire principale des transistors d'entrée. De cette manière on effectue en sortie une soustraction des courants collecteur issus des transistors de la paire annexe d'entrée du courant des collecteurs des transistors opposés de la paire principale des transistors d'entrée. Par rapport à un étage différentiel simple à des transistors seulement, la disposition mentionnée conduit à soustraire des courants aux collecteurs de la paire d'entrée, d'autres courants variant en sens contraire en fonction de la variation de la tension différentielle d'entrée.

Cette disposition possède plusieurs propriétés : notamment celle d'augmenter la transconductance de l'étage différentiel et également d'augmenter la plage de linéarité du courant de sortie en fonction de la tension différentielle d'entrée.

L'évolution actuelle des circuits notamment dans le domaine des convertisseurs analogique-numérique impose d'augmenter le plus possible la plage de linéarité des circuits. Les propriétés de l'étage différentiel connu correspondent dans une certaine mesure à ce besoin.

Toutefois, pour l'application mentionnée il est encore nécessaire que le signal différentiel de sortie de l'amplificateur présente un signal de sortie maximum (en courant ou en tension) assez bien défini, et encore que, lorsque la tension différentielle d'entrée s'étend au-delà de la plage de linéarité du signal de sortie, aucun des transistors de l'étage différentiel ne passe en régime de saturation. En effet, l'amplificateur différentiel perdrait ses propriétés de bande passante, si à un moment donné, au moins un transistor entrait en saturation. L'étage différentiel connu ne possède pas ces propriétés.

Un autre inconvénient de ce circuit provient du fait qu'il met en oeuvre des miroirs de courant à transistors PNP. Il est bien connu que l'orsqu'on utilise une technologie simple et donc bon marché, les transistors de type PNP sont relativement plus lents que les transistors du type NPN. C'est pourquoi le circuit connu serait très limité en bande passante si on envisageait une application dans le domaine grand public pour lequel une haute technologie permettant d'obtenir des transistors PNP rapides n'est pas envisageable parceque trop onéreuse.

L'invention vise donc à une amélioration de la linéarité, et également de préférence, de la transconductance d'un amplificateur différentiel du type précité, qui ne présente pas les inconvénients mentionnés et qui puisse être mis en oeuvre uniquement à l'aide de transistors du type NPN. Un tel amplificateur serait alors réalisable dans une technologie bon marché tout en présentant une excellente bande passante s'étendant dans les fréquences élevées.

Un amplificateur selon l'invention est, dans ce but, caractérisé en ce que l'étage différentiel comporte une paire de transistors cascode dont les trajets collecteurs-émetteurs sont insérés en tant que charge de collecteurs des transistors de la paire principale, et dont les bases sont réunies et connectées à une tension de référence intermédiaire, fixe, et en ce que ladite sommation est effectuée au moyen de deux ponts résistifs, connectés à partir d'une tension d'alimentation vers chacun des collecteurs respectifs des transistors de la paire principale de transistors d'entrée, tandis que les collecteurs des transistors de la paire annexe sont reliés respectivement aux points intermédiaires des ponts résistifs respectifs.

Dans l'amplificateur selon l'invention l'étage de transistors cascode maintient pratiquement la tension des collecteurs des transistors de la paire principale d'entrée à une valeur fixe, des variations de tension émetteur-base des transistors cascode étant négligées. Les collecteurs des transistors de la paire annexe de transistors d'entrée ont une tension qui au contraire, varie avec le signal de tension différentielle d'entrée de sorte qu'un courant variable en fonction de la tension différentielle d'entrée est ajouté - ou retiré - au collecteur des transistors de la paire principale d'entrée. La fonction de sommation algébrique mentionnée plus haut est ainsi réalisée par la combinaison des ponts de résistances et de la présence de la paire de transistors cascode, sans avoir recours à des transistors PNP. De la sorte, l'amplificateur selon l'invention est réalisable dans une technologie simple et bon marché, tout en bénéficiant d'une bande passante élevée.

Comme on le verra plus en détail par la suite, l'amplificateur selon l'invention possède la propriété de fixer une excursion maximale du courant de sortie, ou de la tension de sortie lorsque des charges résistives sont insérées dans les collecteurs des transistors cascode, sans qu'aucun des transistors de l'amplificateur ne passe en régime de saturation.

Dans un mode de réalisation avantageux par sa simplicité, la tension d'alimentation appliquée à une extrémité des ponts de résistance est la même que celle de la borne d'alimentation. Toutefois cette disposition n'est pas indispensable et une autre tension d'alimentation pourrait aussi être choisie, par exemple pour fixer précisément l'excursion en sortie de l'étage différentiel.

Selon un mode de mise en oeuvre préféré, les émetteurs des transistors de la paire annexe d'entrée sont alimentés par une source de courant d'émetteur qui est distincte de celle qui alimente les émetteurs de la paire principale de transistors d'entrée. Selon ce mode de mise en oeuvre, il est plus aisé de déterminer le fonctionnement et notamment le point de repos de l'amplificateur par le choix des valeurs respectives des courants des deux sources de courant d'émetteurs.

L'invention sera mieux comprise à la lecture de la description qui va suivre donnée à titre d'exemple non limitatif, en se référant aux dessins ci-annexés, lesquels représentent :

- la figure 1, le schéma d'un amplificateur différentiel qui servira à fournir des explications pour la comparaison entre l'amplificateur de l'invention et les amplificateurs connus,
- la figure 2, le schéma électrique d'un exemple de réalisation de l'invention,
- la figure 3, des courbes de tension différentielle de sortie comparées entre des dispositifs de l'art antérieur et l'invention.

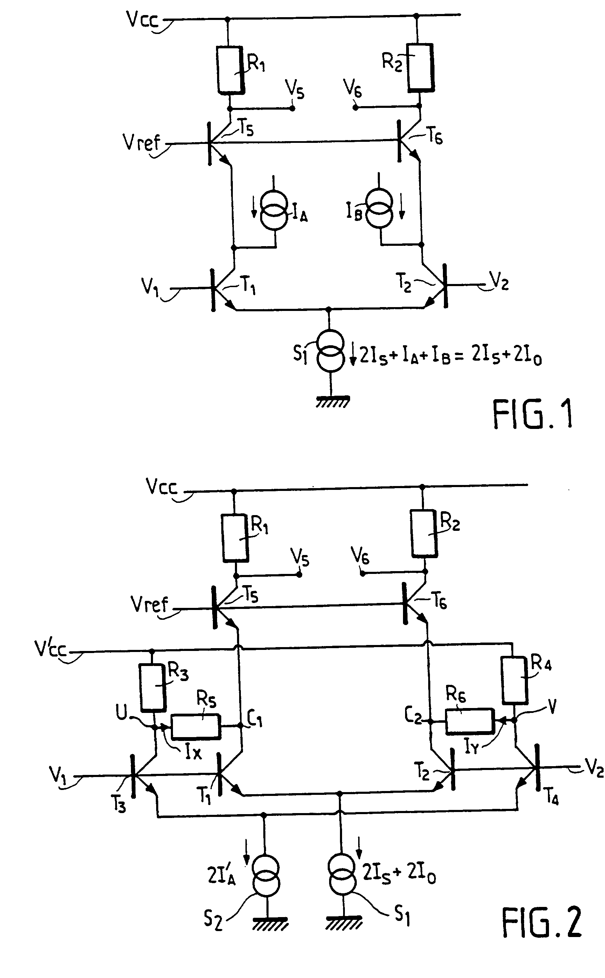

La figure 1 représente un amplificateur comportant un étage différentiel muni d'une seule paire de transistors d'entrée $T_1$, $T_2$, disposée entre une borne d'alimentation $V_{cc}$ et une borne de référence qui est ici la masse. Les émetteurs des transistors d'entrée $T_1$ et $T_2$ sont réunis et alimentés par une source de courant d'émetteur $S_1$ disposée entre ces émetteurs et la masse. La base du transistor $T_1$ reçoit une tension $V_1$ et celle du transistor $T_2$ une tension $V_2$. La tension $(V_1 - V_2) = V_{in}$ est dénommée tension différentielle d'entrée. Une charge est disposée dans le collecteur de chacun des transistors $T_1$ et $T_2$. Telle que représentée ici, elle est constituée par un étage cascode qui met en oeuvre deux transistors $T_5$ et $T_6$ dont les trajets collecteur-émetteur sont insérés en tant que charge de collecteur des transistors de la paire des transistors d'entrée $T_1$ et $T_2$ et dont les bases sont réunies et connectées à une tension de référence intermédiaire $V_{REF}$ qui est fixe. Les collecteurs des transistors de la paire cascode $T_5$, $T_6$ sont reliés respectivement à la borne d'alimentation $V_{cc}$ via des résistances de charge $R_1$ et $R_2$ de valeurs égales. La figure 1 montre encore deux sources de courant annexe $I_A$ et $I_B$ débitant respectivement sur les noeuds qui joignent les émetteurs des transistors de la paire cascode $T_5$ et $T_6$ avec

les collecteurs des transistors $T_1$ et $T_2$ de la paire différentielle d'entrée. Selon un art antérieur connu du document EP-A-0 275 079 dans lequel les transistors sont du type MESFET, les sources de courant annexe $I_A$ et $I_B$ débitent des courants fixes $I_0$ de telle sorte que l'on peut écrire :

$$I_A + I_B = 2I_0.$$

Le courant débité par la source de courant d'émetteur S1 est définie comme égale à $2I_s + 2I_0$. La valeur du courant $I_s$ est déterminée de telle sorte qu'une excursion des tensions de sortie V5 et V6 sur les résistances de charge R1 et R2 se produise dans une plage déterminée de valeurs lorsque la tension différentielle d'entrée $V_{in}$ varie.

Dans le cas d'un amplificateur différentiel classique (sans sources de courant annexes, $I_A$ et $I_B = 0$) et dont la source de courant d'émetteur à pour valeur $2I_s$, la transconductance effective $g_{m1}$ à pour valeur :

$$g_{m1} = I_s/V_T$$

expression dans laquelle $V_T$ correspond à kT/q sensiblement égal à 26mV.

Dans le cas où les sources de courant annexe $I_A$ et $I_B$ débitent chacune un courant $I_0$, un calcul simple montre que la transconductance $g_{m2}$ devient alors égale à :

$$g_{m2} = (I_s + I_0)/V_T > g_{m1}$$

Il est clair que dans ce cas une augmentation du courant de la source de courant d'émetteur $S_1$ conduit à une augmentation de la transconductance de l'amplificateur différentiel ainsi qu'une augmentation corrélative du gain en tension de sortie $(V_5 - V_6)$ par rapport à la tension différentielle d'entrée $V_{in}$.

Une augmentation supplémentaire de transconductance peut être obtenue lorsque les courants débités par les sources annexes de courant $I_A$ et $I_B$ ne sont plus fixes mais varient en sens inverse l'un de l'autre, en fonction de la tension différentielle d'entrée $V_{in}$. Posons :

$$I_A = I_0(1 - f(V_{in}))$$

$$I_B = I_0(1 + f(V_{in}))$$

$f(V_{in})$ étant une fonction monotone croissante de la tension différentielle d'entrée $V_{in}$. La transconductance effective $g_{m3}$ devient alors :

$$g_{m3} = ((I_s + I_0)/V_T) + I_0\ f'(o)$$

expression dans laquelle f'(o) est la dérivée à l'origine de la courbe $f(V_{in})$. Il suffit que la fonction f'(o) soit positive pour que la transconductance $g_{m3}$ soit augmentée et c'est ce qui se produit dans l'amplificateur connu du document JP-A-57 53114, du fait que les sources de courant annexe $I_A$ et $I_B$ représentées à la figure 1 sont alors des courants collecteur d'une paire additionnelle de transistors d'entrée, couplée à la paire principale des transistors d'entrée $T_1$ et $T_2$. Le couplage des collecteurs des transistors de la paire additionnelle de transistors d'entrée est croisé avec les collecteurs de la paire principale d'entrée de manière à réaliser la sommation de courant convenable, produisant la fonction f monotone croissante dont la dérivée a le signe convenable.

Comme il a déjà été mentionné plus haut, l'amplificateur connu, qui n'est par ailleurs pas du type cascode, fait usage de miroirs de courant à transistors PNP. Lorsqu'on envisage d'utiliser une technologie de circuit intégré classique, de tels transistors PNP sont lents et un tel amplificateur différentiel possède une bande passante très limitée.

L'invention se propose de réaliser la même fonction par variation des courants des sources de courant annexe $I_A$ et $I_B$ procurant une augmentation de la transconductance et une augmentation de la linéarité du signal de sortie dans une plage spécifiée, sans avoir recours à des transistors de type PNP. Elle se propose en outre d'éviter qu'aucun des transistors de l'amplificateur ne passe en régime de saturation lorsque la tension différentielle d'entrée dépasse sa plage normale d'utilisation.

La figure 2 représente le schéma d'un exemple d'amplificateur selon l'invention. Selon cette figure, une paire principale de transistors d'entrée $T_1$, $T_2$ une paire de transistors cascode $T_5$, $T_6$, et les résistances de charge $R_1$, $R_2$ sont les mêmes qu'à la figure 1. L'amplificateur représenté comporte en outre une autre paire de transistors d'entrée appelée paire annexe, composée des transistors $T_3$ et $T_4$, transistors dont les émetteurs sont réunis et alimentés à partir d'une source de courant d'émetteur $S_2$. Les bases des transistors homologues des deux paires de transistors d'entrée sont couplées entre elles, les bases réunies des transistors $T_1$ et $T_3$ recevant la tension d'entrée $V_1$ tandis que les bases réunies des transistors $T_2$ et $T_4$ reçoivent la tension d'entrée $V_2$. La différence de tension $V_1 - V_2$ forme comme précédemment la tension différentielle d'entrée $V_{in}$.

La figure 2 indique comment, selon l'invention, sont couplés les collecteurs des transistors de la paire annexe d'entrée avec les collecteurs des transistors de la paire principale d'entrée, de manière à procurer la fonction $f(V_{in})$ recherchée. A cet effet un premier pont résistif est formé des résistances en série $R_3$ et $R_5$ connectées entre une tension d'alimentation $V'_{cc}$ et le collecteur du transistor d'entrée $T_1$. Le point intermédiaire de ce premier pont résistif, noeud U, est connecté au collecteur du transistor $T_3$. Symétriquement, un deuxième pont résistif est formé des résistances $R_4$ et $R_6$, dont une extrémité est également reliée à la tension d'alimentation $V'_{cc}$ et l'autre extrémité au collecteur du transistor $T_2$ tandis que le point intermédiaire de ce deuxième pont résistif, noeud V, est connecté au collecteur du transistor $T_4$. Le noeud de liaison entre l'émetteur du transistor $T_5$, le collecteur du transistor $T_1$ et la résistance $R_5$ est appelée $C_1$ et symétriquement le noeud homologue reliant l'émetteur du transistor $T_6$, le collecteur du transistor $T_2$ et la résistance $R_6$ est appelé $C_2$.

On examinera d'abord le cas où la tension différentielle d'entrée $V_{in}$ est nulle. La tension aux noeuds $C_1$ et $C_2$ est pratiquement imposée par les émetteurs du transistor cascode $T_5$ et $T_6$ et correspond à la tension $V_{REF}$ diminuée d'une tension de jonction en direct. Selon les valeurs choisies, d'une part pour le courant $2I'_A$ de la source annexe de courant d'émetteur $S_2$ et d'autre part pour les résistances $R_3$, $R_5$ et $R_4$, $R_6$ les tensions des noeuds U et V, peuvent être supérieures ou inférieures aux tensions des noeuds $C_1$ et $C_2$. On va supposer que la tension aux noeuds U et V est supérieure à la tension des noeuds $C_1$ et $C_2$, et alors des courant Ix et Iy circulent dans le sens des noeuds U et V vers des noeuds $C_1$ et $C_2$. Ceci correspond alors à des courants $I_A$ et $I_B$ débités dans le même sens que ceux des sources $I_A$ et $I_B$ de la figure 1. On peut également supposer la situation inverse, c'est-à-dire une tension aux noeuds U et V qui soit inférieure à celle des noeuds $C_1$ et $C_2$, mais le raisonnement qui va suivre reste le même.

On se place maintenant dans le cas où la tension d'entrée $V_1$ est supérieure à la tension d'entrée $V_2$, ($V_{in}$ positif). Par rapport à l'état d'équilibre, la tension au noeud U baisse et la tension au noeud V s'élève. La variation du courant $I_x$ par rapport à l'état d'équilibre précédent correspond à un prélèvement de courant sur le collecteur du transistor $T_1$ tandis qu'au contraire la variation de $I_Y$ correspond à une injection de courant sur le collecteur du transistor $T_2$. Ce résultat est bien conforme à la fonction $f(V_{in})$ souhaitée et elle procure à la fois une augmentation de la transconductance de l'amplificateur et une augmentation de la linéarité de la tension de sortie ($V_5 - V_6$) en fonction de $V_{in}$, dans la plage de fonctionnement normal.

L'amplificateur ainsi réalisé possède également l'avantage que les transistors cascode $T_5$ et $T_6$ jouent le rôle d'interrupteurs lorsque la tension différentielle d'entrée $V_{in}$ est plus grande que la plage de fonctionnement normale prévue pour l'amplificateur.

En effet, supposons que la tension différentielle d'entrée $V_{in}$ soit telle que les transistors $T_1$ et $T_3$ sont bloqués. La tension au noeud U remonte à la valeur de $V'_{cc}$ et la tension au noeud $C_1$ fait de même, comme étant lié par la résistance $R_5$. Il suffit de prévoir que la tension $V'_{cc}$ soit suffisante par rapport à la tension $V_{REF}$ pour que le transistor $T_5$ soit bloqué. En définitive les transistors $T_1$, $T_3$ et $T_5$ sont bloqués et la tension de sortie $V_5$ est égale à la tension $V_{cc}$. Dans la branche opposée de l'amplificateur, l'émetteur du transistor $T_2$ est parcouru par la totalité du courant $2I_s + 2I_0$ et l'émetteur du transistor $T_4$ est parcouru par la totalité du courant $2I'_A$. La valeur de la résistance $R_4$ est choisie de telle sorte que la tension au noeud V soit supérieure à celle qui placerait le transistor $T_4$ en saturation. Un courant Iy dont la valeur est aisément prédéterminée est fourni au collecteur du transistor $T_2$. L'émetteur du transistor cascode $T_6$ est parcouru par la différence entre le courant précité et le courant $2I_s + 2I_0$. Le courant collecteur du transistor $T_6$ est sensiblement égal au courant émetteur (à la valeur du courant de base près). La tension de sortie $V_6$ est en conséquence formée par la chute de tension dans la ré-

sistance de charge $R_2$, tension de sortie $V_6$ qui est parfaitement déterminable. On a vu qu'aucun des transistors de l'amplificateur n'est placé en régime de saturation même lorsque la tension différentielle d'entrée $V_{in}$ excède sa plage de fonctionnement normal. La tension différentielle de sortie maximale $V_5 - V_6$ peut donc être prédéterminée facilement.

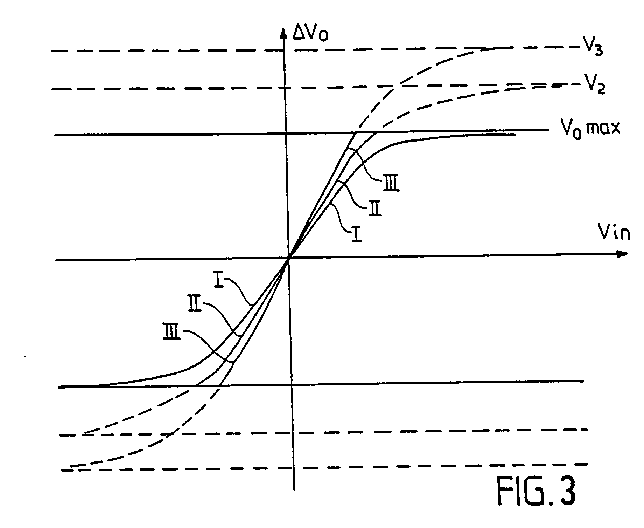

La figure 3 illustre des courbes donnant la tension différentielle de sortie $\Delta V_0 = (V_5 - V_6)$ en fonction de la tension différentielle d'entrée $V_{in}$, pour un étage différentiel classique (courbe I), pour un étage différentiel selon l'art antérieur EP-A-0 275 079 (courbe II), et enfin pour l'amplificateur selon l'invention mettant en oeuvre une fonction $f(V_{in})$ de variation des courants $I_A$ et $I_B$ indiqués à la figure 1.

Relative à un étage différentiel classique dans lequel $I_A$, $I_B = 0$, la courbe I est une tangente hyperbolique d'asymptote $V_{0maX} = 2 R_1 I_S$. Cette courbe montre les défauts d'un tel étage différentiel classique à savoir la zone linéaire de tension de sortie qui est petite devant la plage de fonctionnement représentée par la valeur $V_{0max}$.

La courbe II montre la tension différentielle de sortie $\Delta V_0$ pour un étage différentiel de l'art antérieur dans lequel les courants $I_A = I_B = I_0$. Cette courbe montre d'une part que la transconductance est plus élevée et d'autre part que l'asymptote $V_2$ correspondant à la fonction de la tangente hyperbolique de ce cas, est plus élevée, asymptote déterminée en l'absence de limitation de la tension différentielle de sortie. Etant rapportée à la même valeur de $V_{0max}$ la courbe II montre que la pente est plus élevée (la transconductance est plus élevée) et que la linéarité de la tension différentielle de sortie est meilleure, à l'intérieur de la plage d'utilisation.

La courbe III est relative à l'amplificateur selon l'invention. Du fait que dans ce cas, les courants $I_A$ et $I_B$ (figure 1) ont une valeur variable avec la tension d'entrée $V_{in}$, la transconductance est encore plus élevée et également la valeur asymptotique $V_3$ de $\Delta V_0$ en l'absence de limitation à un $V_{0max}$ déterminé, est également plus élevée.

Il en résulte que l'amplificateur selon l'invention bénéficie d'une transconductance élevée, (et d'autant plus élevée que les courants des sources d'émetteur sont élevés), d'une plage de linéarité de la tension de sortie qui s'étend jusqu'aux limites de la tension de sortie maximale, et le tout sans faire appel à des transistors PNP. En conséquence l'amplificateur selon l'invention est doué d'une bande passante élevée et peut être fabriqué selon une technologie habituelle et peu onéreuse.

Le schéma indiqué à la figure 2 prévoit une tension d'alimentation $V'_{cc}$ distincte de la borne d'alimentation $V_{cc}$. En utilisant une valeur de $V'_{cc}$ régulée il est possible d'obtenir une excursion du signal de sortie qui est indépendante des variations de $V_{cc}$. Toutefois un mode simplifié de mise en oeuvre consiste à relier la ligne $V'_{cc}$ à la ligne $V_{cc}$. D'autre part le mode préféré décrit, prévoit deux sources de courant d'émetteur distinctes $S_1$ et $S_2$

ce qui facilite le contrôle du fonctionnement du circuit. Toutefois, il est également possible de relier les émetteurs des transistors $T_1$, $T_2$, $T_3$ et $T_4$ et de n'utiliser qu'une seule source de courant d'émetteur.

On donne maintenant à titre indicatif quelques valeurs numériques d'un exemple de réalisation du dispositif représenté à la figure 2.

courant débité par la source $S_1 = 1mA$
courant débité par la source $S_2 = 1mA$
$V_{cc} = 5$ Volts
$V'_{cc} = 4,5$ Volts
$V_{REF} = 3,9$ Volts
$V_1$, $V_2 = 1,8$ Volt au repos, $\pm 100$ mV
$R_1 = R_2 = 1k\Omega$
$R_3 = R_4 = 1k\Omega$
$R_5 = R_6 = 3,6k\Omega$

Pour de telles valeurs, lorsque $V_{in} = 0$, les courants Ix et Iy circulent dans le sens allant des noeuds U et V vers les noeuds $C_1$ et $C_2$ respectivement, tandis que pour une tension différentielle d'entrée $V_{in}$ élevée la tension différentielle de sortie $V_{0max} = (V_5 - V_6)$ est limitée à 0,9 Volt avec une plage linéaire d'utilisation de $\pm 0,5$ Volt.

L'invention ne se limite pas au mode de réalisation décrit ci-dessus. Les transistors NPN peuvent être remplacés par des transistors NMOST. Les fonctions de tangente hyperbolique indiquées à propos de la figure 3 diffèrent mais les courbes obtenues dans ce cas ont la même allure et sont plus progressives. On pourrait également mettre en oeuvre plusieurs sources de courant $I_A$ et $I_B$ en parallèle à partir d'autres paires annexes de transistors ainsi que des ponts résistifs supplémentaires pour obtenir des corrections de linéarité plus fines.

**Revendications**

1. Amplificateur comportant un étage différentiel muni de deux paires de transistors d'entrée, disposées entre une borne d'alimentation ($V_{cc}$) et une borne de référence, dans lesquelles une paire ($T_1$, $T_2$) appelée paire principale de transistors d'entrée est alimentée par ses émetteurs réunis, par une source de courant d'émetteur ($S_1$) qui est connectée par ailleurs à la borne de référence, et une autre paire ($T_3$, $T_4$) appelée paire annexe de transistors d'entrée, est alimentée de manière similaire par ses émetteurs réunis, les bases des transistors de la paire principale étant réunies aux bases homologues des transistors de la paire annexe, et formant les bornes d'entrée pour des tensions d'entrée ($V_1$, $V_2$) - tensions d'entrée dont la différence définit une tension différentielle d'entrée ($V_{in}$) - tandis qu'au moins une partie des courants des collecteurs des transistors de la paire annexe est utilisée en sommation convenable avec les courants des collecteurs des transistors de la paire principale - laquelle sommation formant des courants de sortie de l'étage différentiel - en vue d'augmenter la linéarité de ces courants de sortie par rapport à la tension différentielle d'entrée, caractérisé en ce que l'étage différentiel comporte une paire de transistors cascode ($T_5$, $T_6$) dont les trajets collecteurs-émetteurs sont insérés en tant que charge des collecteurs des transistors de la paire principale, et dont les bases sont réunies et connectées à une tension de référence intermédiaire ($V_{ref}$), fixe, et en ce que ladite sommation est effectuée au moyen de deux ponts résistifs, connectés à partir d'une tension d'alimentation ($V'_{cc}$) vers chacun des collecteurs respectifs des transistors de la paire principale de transistors d'entrée, tandis que les collecteurs des transistors de la paire annexe sont reliés respectivement aux points intermédiaires (U, V) des ponts résistifs respectifs.

2. Amplificateur selon la revendication 1, caractérisé en ce que ladite tension d'alimentation est la même tension que celle de la borne d'alimentation.

3. Amplificateur selon l'une des revendication 1 ou 2, caractérisé en ce que les émetteurs des transistors de la paire annexe d'entrée sont alimentés par une source de courant d'émetteur qui est distincte de celle qui alimente les émetteurs de la paire principale de transistors d'entrée.

## Claims

1. An amplifier having a differential stage comprising two input transistor pairs arranged between a supply terminal ($V_{cc}$) and a reference terminal, the coupled emitters of one pair ($T_1$, $T_2$) called the main pair of input transistors being driven by an emitter current source ($S_1$), which is also connected to the reference terminal, and the coupled emitters of another pair ($T_3$, $T_4$) called the auxiliary pair of input transistors being driven in a similar way, the bases of the transistors of the main pair being coupled to the corresponding bases of the transistors of the auxiliary pair and forming the input terminals for input voltages ($V_1$, $V_2$) - the difference of which input voltages defines a differential input voltage ($V_{in}$) - whilst at least a part of the collector currents of the transistors of the auxiliary pair is used for a suitable summation with the collector currents of the transistors of the main pair - which summation yields output currents of the differential stage - in order to improve the linearity of said output currents with respect to the differential input voltage, characterised in that the differential stage comprises a pair of cascode transistors ($T_5$, $T_6$) whose collector-emitter paths are arranged as collectors loads of the transistors of the main pair, and whose bases are coupled to one another and connected to a fixed intermediate reference voltage ($V_{ref}$), and said summation is effected by means of two resistive bridges connected between a supply voltage ($V'_{cc}$) and each of the respective collectors of the transistors of the main pair of input transistors, the collectors of the transistors of the auxiliary pair being coupled to the respective nodes (U, V) of respective resistive bridges.

2. An amplifier as claimed in Claim 1, characterised in that said supply voltage is the same voltage as that on the supply terminal.

3. An amplifier as claimed in Claim 1 or 2, characterised in that the emitters of the transistors of the auxiliary input pair are driven by an emitter current source distinct from that driving the emitters of the main pair of input transistors.

## Patentansprüche

1. Verstärker mit einer Differenzstufe mit zwei Eingangstransistorpaaren zwischen einer Speiseklemme ($V_{cc}$) und einer Bezugsklemme, wobei die miteinander verbundenen Emitter-Elektroden eines als Hauptpaar bezeichneten Eingangstransistorpaares ($T_1$, $T_2$) von einer Emitterstromquelle ($S_1$) betrieben werden, die ebenfalls mit der Bezugsklemme verbunden ist, und wobei die miteinander verbundenen Emitter-Elektroden des anderen als Hilfspaar bezeichneten Eingangstransistorpaares ($T_3$, $T_4$) auf entsprechende Weise betrieben werden, wobei die Basis-Elektroden der Transistoren des Hauptpaares mit den entsprechenden Basis-Elektroden der Transistoren des Hilfspaares verbunden sind und die Eingangsklemmen für die Eingangsspannungen ($V_1$, $V_2$) bilden, deren Differenz eine Differenzeingangsspannung ($V_{in}$) definiert, wobei ein Teil der Kollektorströme der Transistoren des Hilfspaares für eine geeignete Summierung mit den Kollektor-Elektroden der Transistoren des Hauptpaares verwendet werden, wobei diese Summierung zu Ausgangsströmen der Differenzstufe führt, damit die Linearität der genannten Ausgangsströme im Vergleich zu der Differenzeingangsspannung zunimmt, <u>dadurch gekennzeichnet</u>, daß die Differenzstufe ein Paar kaskodengeschalteter Transistoren ($T_5$, $T_6$) aufweist, deren Kollektor-Emitter-Strecken als Last in den Kollektor-Elektroden der Transistoren des Hauptpaares vorgesehen sind, und deren Basis-Elektroden miteinander und mit einer festen Zwischenbezugsspannung ($V_{ref}$) verbunden sind, und daß die genannte Summierung mit Hilfe von zwei Widerstandsbrücken zwischen einer Speisespannung ($V'_{cc}$) und jedem der betreffenden Kollektor-Elektroden der Transistoren des Hauptpaares von Eingangstransistoren durchgeführt wird, wobei die Kollektor-Elektroden der Transistoren des Hilfspaares mit den betreffenden Knotenpunkten (U, V) der betreffenden Widerstandsbrücken verbunden sind.

2. Verstärker nach Anspruch 1, dadurch gekennzeichnet, daß die genannte Speisespannung dieselbe Spannung ist, wie die an der Speiseklemme.

3. Verstärker nach einem der Ansprüche 1 oder 2, dadurch gekennzeichnet, daß die Emitter-Elektroden der Transistoren des Hilfseingangspaares von einer Emitterstromquelle gespeist werden, die sich von der zum Speisen der Emitter-Elektroden des Hauptpaares von Eingangstransistoren unterscheidet.

FIG. 1

FIG. 2

8

FIG.3